# NOUVEAU FASCICULE DE BREVET EUROPEEN

(11) **EP 3 030 530 B2**
(45) Date de publication et mention de la décision concernant l'opposition: **24.05.2023**
(45) Mention de la délivrance du brevet: 01.04.2020
(21) Numéro de dépôt: 14755884.5
(22) Date de dépôt: 05.08.2014
(51) Int. Cl.: C03C 17/32, C03C 17/36, C03C 17/42, B05D 1/28, C23C 14/34

(54) **SUBSTRAT PORTANT UN REVETEMENT FONCTIONNEL ET UNE COUCHE DE PROTECTION TEMPORAIRE**
SUBSTRAT MIT EINER FUNKTIONELLEN BESCHICHTUNG UND EINER TEMPORÄREN SCHUTZSCHICHT
SUBSTRATE HAVING A FUNCTIONAL COATING AND A TEMPORARY PROTECTION LAYER

(30) Priorité: 05.08.2013 FR 1357778
(43) Date de publication de la demande: 15.06.2016
(73) Titulaire: SAINT-GOBAIN GLASS FRANCE, 92400 Courbevoie (FR)
(72) Inventeur: NADAUD, Nicolas, F-75013 Paris (FR); MORLENS, Stéphanie, F-75018 Paris (FR); RACHET, Vincent, F-92120 Montrouge (FR)
(74) Mandataire: Saint-Gobain Recherche
(86) Numéro de dépôt international: PCT/FR2014/052040
(87) Numéro de publication internationale: WO 2015/019022

(56) Documents cités:
- FR-A1- 2 879 188
- FR-A1- 2 879 188
- US-A1- 2002 176 988
- US-A1- 2002 176 988
- US-A1- 2005 181 219
- US-A1- 2005 181 219
- US-A1- 2007 231 553
- US-A1- 2008 302 462
- US-A1- 2009 044 897
- US-A1- 2009 258 187
- US-A1- 2011 081 502
- US-A1- 2012 009 388
- US-A1- 2012 009 388

## Description

L'invention concerne la protection des substrats, de préférence en verre, portant au moins un revêtement fonctionnel. Ces substrats sont destinés à subir des étapes de transport, de transformation et/ou de stockage.

Il est connu d'utiliser des articles comprenant des substrats portant des revêtements fonctionnels afin de conférer auxdits substrats des propriétés optiques (couches miroirs ou antireflets), thermiques (couches bas-émissives, contrôle solaire ou antisolaires, notamment à base de couches d'argent) ou électriques (couches antistatiques, couches conductrices transparentes).

Beaucoup de revêtements fonctionnels déposés sur des substrats présentent une résistance mécanique faible notamment une aptitude à la rayure élevée et une faible résistance à l'abrasion. Enfin, certains revêtements fonctionnels sont sujets à la corrosion lors du stockage notamment en milieu humide.

En particulier, les substrats portant des revêtements fonctionnels à base de couches métalliques, par exemple à base d'argent ou d'alliage à base d'argent, présentent ces inconvénients. Ces substrats sont généralement utilisés en vitrage feuilleté ou multiple, double ou triple, pour des applications dites de contrôle solaire et/ou de basse émissivité. Les revêtements fonctionnels sont alors volontairement encapsulés dans le vitrage.

Des substrats en verre portant des revêtements fonctionnels de ce type sont par exemple vendus par la société Saint-Gobain sous la dénomination Cool Lite^{®}. Ces substrats présentent de très bonnes performances optiques (TL, couleur) et thermiques (facteur solaire). Ces performances sont obtenues grâce à des revêtements fonctionnels comprenant des empilements complexes avec notamment plus d'une dizaine de couches minces d'épaisseur et de nature différentes.

Ces substrats subissent des étapes de transformation diverses telles que des étapes de découpe, de lavage, de façonnage des bords, d'assemblage et/ou de traitements thermiques de type trempe, recuit et/ou bombage. Il est courant et pratique de réaliser l'assemblage et/ou les traitements divers sur un lieu autre que celui où est fabriqué le substrat portant le revêtement fonctionnel. Ces substrats subissent donc également des étapes de stockage et de transport.

Les sollicitations mécaniques susceptibles de générer des altérations de type rayures sont multiples et comprennent notamment :
- l'étape de stockage des substrats après dépôt du revêtement fonctionnel sur le lieu de production,
- l'étape de déplacement des substrats, empilés ou non, du lieu de production vers le lieu de transformation,
- l'étape de façonnage et de stockage sur le lieu de transformation,
- l'étape de lavage en milieu humide réalisée par exemple avant un traitement thermique ou un assemblage en double vitrage (DGU) ou en triple vitrage (TGU),
- les étapes de passage sur des rouleaux, par exemple sur les rouleaux du four en vue d'un traitement thermique notamment dans le cas de substrats dits bi-fonctionnalisés portant des revêtements fonctionnels sur chaque face.

La visibilité des rayures une fois créées augmente de manière considérable lorsque le substrat est soumis à un traitement thermique de type trempe. L'aptitude à la rayure des tels substrats est préjudiciable du point de vue de l'esthétisme et du rendement de production. En effet, des rayures non visibles avant traitement thermique, qui ne se révèlent qu'après, peuvent entraîner un taux de rebut anormalement élevé. La perte financière est alors encore plus élevée car le substrat mis au rebut intègre le coût du traitement thermique.

Les revêtements fonctionnels complexes et notamment ceux comprenant des couches minces métalliques à base d'argent présentent également une faible résistance à l'abrasion. Ces sollicitations mécaniques peuvent induire des défauts autres que des rayures tels que l'arrachement partiel ou total d'une ou plusieurs couches du revêtement fonctionnel.

Des phénomènes de corrosion peuvent également se produire selon la nature des matériaux constituant les revêtements fonctionnels. Mais surtout, leur occurrence est fortement dépendante des conditions d'humidité, de température et de la durée des différentes étapes de déplacement, stockage, lavage et/ou traitement thermique. Les revêtements fonctionnels comprenant notamment des couches métalliques ou des couches à base d'oxydes hygroscopiques sont sensibles à l'humidité.

Tous défauts ou rayures du revêtement fonctionnel, qu'ils soient dus à la corrosion ou à des sollicitations mécaniques, sont susceptibles d'altérer non seulement l'esthétique mais également les performances optiques et/ou énergétiques du substrat. La manipulation de substrats portant de tels revêtements requiert beaucoup de précautions lors des étapes de transport, de transformation et/ou de stockage.

Il est connu de protéger la surface du substrat par des films polymères adhésifs pelables. Ces films peuvent être déposés à l'état solide (comme par exemple dans la demande EP-A-1 610 940), ou à l'état liquide (brevet US 5,866,199). Ces solutions utilisant des films pelables présentent pour inconvénients :
- un cout élevé,
- une étape de pelage longue, fastidieuse et susceptible de laisser des traces de l'agent assurant la liaison entre le substrat et le film,
- une possible délamination du revêtement fonctionnel lors de la phase de pelage, et
- la nécessité de gérer les rebuts de films pelés.

Le dépôt d'un même film pelable à l'état solide sur des substrats de grande taille est parfois difficile et peut nécessiter l'utilisation de plusieurs films. Des problèmes se posent à la jonction des films :
- soit une partie du revêtement fonctionnel n'est pas couverte par l'un ou l'autre des films et dans ce cas la protection est incomplète,
- soit les films se chevauchent, ce qui entraîne potentiellement des risques lors de la découpe du substrat.

Des films polymères obtenus à partir d'une phase liquide et pouvant être enlevés par nettoyage à l'aide de solutions aqueuses ont également été développés. La demande WO 00/50354 divulgue par exemple des films obtenus à partir de solutions aqueuses de polymères acryliques facilement éliminables à l'eau, puisque le polymère est lui-même soluble dans l'eau.

La demande WO 01/02496 divulgue un revêtement destiné à protéger temporairement un substrat pendant une étape de transport, de manipulation ou de stockage, par l'application d'un revêtement protecteur amovible. Le revêtement peut être un film obtenu à partir de solutions aqueuses de polymères. Les polymères constituant le film peuvent être choisis parmi les homopolymères ou copolymères d'amidon ou de caséine, les polymères dérivés de protéines, les polymères acryliques, les polyacrylamides, les polymères d'oxyde de polyalkylène, l'acétate de polyvinyle, les alcools polyvinylique, la polyvinylpyrrolidone, les copolymères styrène / acide acrylique, les copolymères éthylène / acide acrylique, les copolymères cellulosiques et les dérivés de la cellulose.

Le revêtement protecteur est préférentiellement éliminé par lavage aqueux. Selon un mode de réalisation non préférentiel, ce revêtement peut également être éliminé par décomposition thermique ou combustion.

Les couches de protection temporaire éliminables durant le lavage ne sont pas susceptibles de protéger le substrat contre la corrosion humide durant le stockage. Mais surtout, ces couches ne protègent pas le revêtement fonctionnel pendant les phases de lavage. De plus, elles présentent en outre l'inconvénient de provoquer une pollution de la machine à laver du transformateur.

Les solutions de l'art antérieur ne sont pas suffisamment efficaces pour limiter le contact entre le revêtement fonctionnel et les éléments chimiques incluant l'eau liquide ou la vapeur d'eau, pouvant entraîner une corrosion à froid durant les différentes étapes de stockage et/ou de transformation.

Il existe donc un besoin de protéger temporairement les substrats portant un revêtement fonctionnel pendant les étapes de fabrication, de transformation, de transport et/ou de stockage. La protection temporaire doit être suffisamment durable pour permettre une protection de la surface du substrat à la fois contre les altérations physiques, contre la corrosion en milieu humide ou lors d'une étape de lavage.

A cet effet, l'invention a pour objet un article comprenant un substrat comprenant deux faces principales définissant deux surfaces principales séparées par des bords, ledit substrat portant :
- un revêtement fonctionnel déposé par pulvérisation cathodique assistée par un champ magnétique sur au moins une partie d'une surface principale et
- une couche de protection temporaire déposée sur au moins une partie du revêtement fonctionnel,
caractérisé en ce que :
- la couche de protection temporaire a une épaisseur d'au moins 1 micromètre,
- la couche de protection temporaire est non soluble dans l'eau,
- la couche de protection temporaire est obtenue à partir d'une composition comprenant des composés (méth)acrylates,
- le substrat portant le revêtement fonctionnel n'a pas subi de traitement thermique à une température supérieure à 400 °C.

La couche de protection temporaire est durcie par séchage, par cuisson IR, par irradiation UV ou par faisceau d'électrons.

La couche de protection temporaire est obtenue à partir d'une composition liquide comprenant des composés (méth)acrylates choisis parmi des monomères, des oligomères, des prépolymères ou des polymères comprenant au moins une fonction (méth)acrylate.

La couche de protection temporaire selon l'invention est spécifiquement destinée à être éliminée lors d'un traitement thermique de type trempe, recuit et/ou bombage à une température suffisante pour permettre son élimination par décomposition thermique. De manière surprenante, cette couche de protection temporaire est éliminée sans nuire aux propriétés optiques du substrat portant le revêtement fonctionnel. Une seule et même étape de traitement thermique du substrat protégé permet d'éliminer la protection du substrat et de conférer au substrat certaines propriétés ou conformation (substrat trempé et/ou bombé).

De préférence, le substrat protégé, c'est-à-dire le substrat portant la couche de protection temporaire n'a pas subi de traitement thermique de type trempe, recuit et/ou bombage, c'est-à-dire de traitement thermique à une température supérieure à 200 °C ou supérieure à 400 °C. Le substrat protégé n'est pas trempé et/ou bombé.

De préférence, le substrat portant le revêtement fonctionnel n'a pas subi de traitement thermique à température élevée de type trempe, recuit et/ou bombage, c'est-à-dire de traitement thermique à une température supérieure à 200 °C ou supérieure à 400 °C. Cela signifie que l'article formé par le substrat et le revêtement fonctionnel n'a pas subi de traitement thermique à température élevée. Cela signifie également que le procédé ne comporte pas d'étape de traitement thermique à température élevée, c'est-à-dire de traitement thermique à une température supérieure à 200 °C ou supérieure à 400 °C, entre le dépôt du revêtement fonctionnel et le dépôt de la couche de protection temporaire.

Cette couche de protection temporaire comprend essentiellement des matériaux organiques de type polymère (méth)acrylate. Sa formulation chimique permet une combustion rapide et complète durant un traitement thermique et ne génère lors de sa décomposition que des molécules volatiles faciles à éliminer.

Cette couche non soluble dans l'eau permet d'obtenir une protection efficace lors de l'étape de lavage et contre la corrosion humide.

De façon surprenante, la protection est conservée même lorsque le substrat subit des découpes successives. En effet, les substrats protégés selon l'invention semblent protégés des mécanismes de corrosion qui pourraient s'initier d'une part en pleine face mais également à partir du bord de découpe. Les substrats protégés selon l'invention peuvent donc être découpés plusieurs fois sans nécessiter de modifier la couche de protection et sans perdre les fonctions de protection mécanique et chimique.

L'invention a également pour objet le procédé de protection dudit article. Dans la suite du texte, les modes de réalisation préférés s'appliquent de la même manière aux différents objets de l'invention, le substrat et le procédé.

La demande WO 01/02496 ne mentionne pas de polymères comparables aux composés (méth)acrylates utilisés selon l'invention. Cette demande divulgue préférentiellement des couches protectrices organiques solubles dans l'eau notamment à base d'alcool polyvinylique facilement hydrolysables. De telles couches ne répondent pas à la problématique de l'invention qui est notamment de résister à la corrosion en milieu humide et/ou au lavage avant transformation.

Mais surtout, bien que ce document envisage l'élimination d'une couche de protection temporaire organique par décomposition thermique lors d'un traitement de type trempe, il dissuade de procéder ainsi. En effet, il est expressément mentionné que l'élimination par combustion n'est pas préférentiellement utilisée lorsque les substrats comprennent un revêtement fonctionnel déposé par pulvérisation cathodique assistée par un champ magnétique (magnétron).

De manière surprenante, la couche de protection temporaire selon l'invention peut être totalement éliminée lors d'un traitement thermique par décomposition sans nuire aux propriétés optiques, énergétiques ou thermiques conférées au substrat par le revêtement fonctionnel. Ces propriétés avantageuses sont obtenues même lorsque le revêtement fonctionnel a été déposé par pulvérisation cathodique magnétron.

La couche de protection temporaire selon l'invention est destinée à être appliquée de préférence en sortie de la ligne de fabrication des substrats portant des revêtements fonctionnels. L'étape de dépôt peut être facilement intégrée dans le procédé de fabrication du substrat portant le revêtement fonctionnel.

L'application d'une couche de protection temporaire obtenue à partir d'une composition liquide essentiellement exempte de solvant et durcie de préférence par irradiation UV, par cuisson IR ou par faisceau d'électrons est particulièrement avantageuse. Le choix de cette technologie sans solvant simplifie de manière considérable la mise en oeuvre industrielle d'un procédé comprenant une étape d'application d'une telle couche. L'absence de solvant permet d'éviter la mise en place d'un dispositif de séchage, de récupération, de traitement des vapeurs de solvant qui ne doivent pas être émises dans l'atmosphère. Les modifications à apporter peuvent se limiter à insérer en fin de ligne un dispositif de dépôt par exemple par enduction au rouleau « roller coater » ainsi qu'un dispositif de réticulation tel qu'une lampe UV.

La composition liquide présente, grâce au choix judicieux des composés (méth)acrylates, une viscosité adaptée pour permettre d'obtenir facilement une couche de protection temporaire d'épaisseur supérieure ou égale à 1 µm et une réactivité suffisante pour permettre une réticulation quasiment instantanée sur toute l'épaisseur. La nature chimique, le degré de réticulation, la densité ainsi que l'épaisseur de la couche de protection temporaire concourent à l'obtention d'une protection efficace contre l'abrasion, l'apparition de rayures et la corrosion. Ces propriétés de protection sont obtenues pour des épaisseurs inférieures à 50 micromètres.

Enfin, l'absence de solvant couplée au durcissement quasiment instantané par exemple par irradiation UV ou par faisceau d'électrons permet d'obtenir des substrats protégés sans incidence sur les cadences de fabrication. Avantageusement, les vitesses d'enduction sont compatibles avec les vitesses de dépôt des revêtements fonctionnels ce qui permet une fabrication continue des substrats portant un revêtement fonctionnel et une couche de protection temporaire selon l'invention. Par exemple, les vitesses d'application de la couche de protection temporaire, comprenant par exemple l'enduction et la réticulation, peuvent être comprises entre 1 et 90 m/min sur un substrat de largeur 1 m à 3,3 m.

Bien que l'invention convienne tout particulièrement pour la protection de substrats portant des revêtements fonctionnels mécaniquement faibles, la solution de l'invention peut s'appliquer à la protection de substrats portant tous types de revêtement fonctionnel.

Le revêtement fonctionnel comprend au moins une couche fonctionnelle. La couche fonctionnelle est de préférence une couche pouvant agir sur le rayonnement solaire et/ou le rayonnement infrarouge de grande longueur d'onde. Ces couches fonctionnelles sont par exemple des couches fonctionnelles métalliques à base d'argent ou d'alliage métallique contenant de l'argent.

Le substrat peut comprendre un revêtement fonctionnel comprenant un empilement de couches minces comportant successivement à partir du substrat une alternance de n couches métalliques fonctionnelles, notamment de couches fonctionnelles à base d'argent ou d'alliage métallique contenant de l'argent, et de (n+1) revêtements antireflets, chaque revêtement antireflet comportant au moins une couche diélectrique, de manière à ce que chaque couche métallique fonctionnelle soit disposée entre deux revêtements antireflets.

Le substrat peut comprendre un empilement de couches minces comportant successivement à partir du substrat une alternance de deux couches métalliques fonctionnelles, notamment de couches fonctionnelles à base d'argent ou d'alliage métallique contenant de l'argent, et de trois revêtements antireflets, chaque revêtement antireflet comportant au moins une couche diélectrique, de manière à ce que chaque couche métallique fonctionnelle soit disposée entre deux revêtements antireflets.

Le substrat peut également comprendre un empilement de couches minces comportant successivement à partir du substrat une alternance de trois couches métalliques fonctionnelles, notamment de couches fonctionnelles à base d'argent ou d'alliage métallique contenant de l'argent, et de quatre revêtements antireflets, chaque revêtement antireflet comportant au moins une couche diélectrique, de manière à ce que chaque couche métallique fonctionnelle soit disposée entre deux revêtements antireflets.

L'épaisseur du revêtement fonctionnel est :
- supérieure à 100 nm, de préférence supérieure à 150 nm,
- inférieure à 300 nm, de préférence inférieure à 250 nm.

Selon un mode de réalisation particulièrement avantageux de l'invention, le revêtement fonctionnel comprend une couche supérieure choisie parmi les nitrures, oxydes ou oxy-nitrures de titane, de zirconium et/ou d'hafnium. La couche supérieure du revêtement fonctionnel est la couche la plus éloignée du substrat et/ou la couche en contact direct avec la couche de protection temporaire.

De manière surprenante, le demandeur a découvert qu'il existe une synergie entre une couche supérieure à base de titane, de zirconium et/ou de hafnium et la couche de protection temporaire. Cette synergie se traduit notamment par l'absence totale de défaut en surface ainsi que par de très faibles variations colorimétriques entre le produit avant et après trempe. Enfin, la synergie se traduit également par un très faible flou après trempe.

La couche supérieure peut en particulier être une couche :
- de nitrure de titane ; de nitrure de zirconium ; de nitrure d'hafnium ; de nitrure de titane et de zirconium ; de nitrure de titane, de zirconium et d'hafnium ;
- d'oxyde de titane ; d'oxyde de zirconium ; d'oxyde d'hafnium ; d'oxyde de titane et de zirconium ; d'oxyde de titane, de zirconium et d'hafnium.

L'épaisseur de ces couches supérieures est préférentiellement comprise entre 1 et 20 nm et mieux comprise entre 1 et 5 nm.

Selon une variante, la couche supérieure peut être une couche de nitrure de silicium éventuellement dopé à l'aluminium. L'épaisseur de cette couche supérieure est préférentiellement comprise entre 5 et 50 nm et mieux comprise entre 10 et 50 nm.

Le revêtement fonctionnel peut être déposé par tout moyen connu tel que par pulvérisation cathodique assistée par un champ magnétique, par évaporation thermique, par CVD ou PECVD, par pyrolyse, par dépôt par voie chimique, par voie de type sol-gel ou dépôt de couches inorganiques par voie humide.

Le revêtement fonctionnel est de préférence déposé par pulvérisation cathodique assistée par un champ magnétique. Selon ce mode de réalisation avantageux, toutes les couches du revêtement fonctionnel sont déposées par pulvérisation cathodique assistée par un champ magnétique. La couche de protection temporaire est avantageusement directement au contact du revêtement fonctionnel.

La couche de protection temporaire est essentiellement de nature organique. Les composés (méth)acrylates ayant réagis rentre eux représentent au moins 90% en masse de la masse de la couche de protection temporaire.

Par (méth)acrylate, on entend un acrylate ou un méthacrylate. On entend par « composés (méth)acrylate », les esters de l'acide acrylique ou méthacrylique comportant au moins une fonction acroyle (CH2=CH-CO-) ou méthacroyle (CH2=CH(CH3)-CO-). Ces esters peuvent être des monomères, des oligomères, des pré-polymères ou des polymères. Ces composés (méth)acrylate, lorsqu'ils sont soumis aux conditions de polymérisation, donnent un réseau polymère doté d'une structure solide.

Les composées (méth)acrylate utilisés selon l'invention peuvent être choisis parmi les (méth)acrylates monofonctionnels et polyfonctionnels tels que les (méth)acrylates mono-, di-, tri-, poly-fonctionnels. Des exemples de tels monomères sont :
- les (méth)acrylates monofonctionnels tels que le méthyl(méth)acrylate, éthyl(méth)acrylate, n- ou ter-butyl(méth)acrylate, hexyl(méth)acrylate, cyclohexyl(méth)acrylate, 2-éthylhexyl(méth)acrylate, benzyl(méth)acrylate, 2-éthoxyethyl(méth)acrylate, phenyloxyethyl(méth)acrylate, hydroxyethylacrylate, hydroxypropyl(méth)acrylate, vinyl(méth)acrylate caprolactone acrylate, isobornyl méthacrylate, lauryl methacrylate, polypropylène glycol monométhacrylate,
- les (méth)acrylates difonctionnels tels que 1,4-butanediol di(méth)acrylate, éthylène diméthacrylate, 1,6-hexandiol di(méth)acrylate, bisphénol A di(méth)acrylate, triméthylolpropane diacrylate, triéthylène glycol diacrylate, éthylène glycol di(méth)acrylate, polyéthylène glycol di(méth)acrylate, le tricyclodécane diméthanol diacrylate,
- les (méth)acrylates trifonctionnels tels que triméthylolpropane triméthacrylate, triméthylolpropane triacrylate, pentaérythritol triacrylate, ethoxylated trimethylolpropane triacrylate, trimethylolpropane triméthacrylate, tripropylène glycol triacrylate,
- les (méth)acrylate de fonctionnalité supérieure tels que pentaérythritol tétra(méth)acrylate, ditriméthylpropane tétra(méth)acrylate, dipentaérythritol penta(méth)acrylate ou hexa(méth)acrylate.

Selon un mode de réalisation avantageux, la couche de protection temporaire ne comprend pas de matière de remplissage minérale telle que des charges ou des pigments. La couche de protection temporaire ne comprend pas non plus d'additifs non susceptibles d'être éliminés lors du traitement thermique tels que des composés organiques comprenant du silicium de type siloxanes.

La couche de protection temporaire présente une épaisseur :
- supérieure à 1 micromètre, de préférence supérieure à 5 micromètres,
- inférieure à 100 micromètres, de préférence inférieure à 50 micromètres,
- comprise entre 2 et 100 micromètres, entre 5 et 50 micromètres ou entre 10 et 30 micromètres.

La couche de protection temporaire présente un grammage compris entre 5 et 50 g/m², de préférence entre 10 et 30 g/m².

Selon des modes de réalisations avantageux de l'invention, la composition liquide présente les caractéristiques suivantes :
- la composition liquide comprend moins de 20% en masse de solvant par rapport à la masse totale de la composition liquide,
- la composition liquide comprend moins de 10% en masse de solvant par rapport à la masse totale de la composition liquide,
- la composition liquide est sans solvant,
- la composition liquide présente une viscosité mesurée à 25 °C :
   - d'au moins 0,05 Pa.s, d'au moins 0,08 Pa.s, d'au moins 0,1 Pa.s, d'au moins 0,50 Pa.s,
   - d'au plus 5 Pa.s, d'au plus 2 Pa.s,
   - comprise entre 0,05 et 5 Pa.s ;
- la composition liquide comprend au moins un initiateur de polymérisation, de préférence un photoinitiateur,
- l'initiateur de polymérisation représente 0,1 à 20 %, ou 1 à 15 %, de préférence 5 à 15 % et mieux 8 à 12 % en masse de la masse totale des composés (méth)acrylates,
- la composition liquide comprend en outre au moins un additif choisi parmi les plastifiants, les absorbeurs, des agents de séparation, des stabilisants à la chaleur et/ou à la lumière, des agents épaississants ou des modificateurs de surface,
- la somme de tous les additifs est comprise entre 0 et 5 % en masse de la masse de la composition liquide,
- les composés (méth)acrylates choisis parmi les esters de l'acide acrylique ou méthacrylique comportant au moins deux fonctions acroyle (CH2=CH-CO-) ou méthacroyle (CH2=CH(CH3)-CO-),
- la composition liquide comprend en masse par rapport à la masse totale des composés (méth)acrylates, par ordre de préférence croissant, au moins 50 %, au moins 60 %, au moins 70 %, au moins 80 %, au moins 90 %, 100 % de composés (méth)acrylates choisis parmi les esters de l'acide acrylique ou méthacrylique comportant au moins deux fonctions acroyle (CH2=CH-CO-) ou méthacroyle (CH2=CH(CH3)-CO-),
- la composition liquide comprend :
   - au moins un oligomère uréthane-acrylique aliphatique,
   - au moins un monomère (méth)acrylate choisi parmi les monomères (méth)acrylates mono, bi, tri-fonctionnel,
   - au moins un initiateur de polymérisation,
- la composition liquide comprend :
   - au moins un oligomère uréthane-acrylique aliphatique,
   - au moins un monomère (méth)acrylate difonctionnel,
   - au moins un monomère (méth)acrylate trifonctionnel,
   - au moins un initiateur de polymérisation, de préférence un photoinitiateur,
- la composition liquide comprend en masse par rapport à la masse totale des composés (méth)acrylates :
   - 30 à 80 % en masse d'au moins un oligomère uréthane-acrylique aliphatique,
   - 20 à 70 % en masse d'au moins au moins un monomère (méth)acrylate choisi parmi un (méth)acrylate mono, bi, tri fonctionnel.

Selon l'invention, les initiateurs de polymérisation ne sont pas considérés comme des additifs.

La composition liquide peut être appliquée à température ambiante par tout moyen connu et notamment par enduction au rouleau, par aspersion, par trempage, par enduction au rideau, ou par pistoletage. La composition liquide est préférentiellement appliquée par enduction au rouleau. La vitesse de dépôt de la composition liquide peut être comprise entre 1 et 90 m/min.

La couche de protection temporaire peut être durcie :
- par séchage à une température inférieure à 200°C pendant une durée allant par exemple de 10 s à 180 s,
- par réticulation UV (différentes longueurs d'onde) de préférence à l'air libre et à température ambiante ou
- par faisceau d'électron.

La composition liquide comprend en outre un initiateur de polymérisation dont la nature est fonction du type de durcissement choisi. Par exemple, en cas de durcissement thermique, on utilise des initiateurs de type peroxyde de benzoyle. En cas de durcissement par rayonnement UV, on utilise des initiateurs dits photoinitiateurs.

Le substrat à protéger doit supporter un traitement thermique au-delà de 200°C, de préférence au-delà de 400 °C. L'invention concerne donc tout substrat constitué de matériaux résistants à ces températures sans altération majeure. A titre de substrat, on peut citer les substrats en verre, les substrats en vitro-céramique, les substrats en céramique, les substrats en acier, les substrats en métal à point de fusion supérieur à 250°C. Le substrat est de préférence un substrat en verre.

Avantageusement, le substrat portant la couche de protection temporaire n'a pas subi de traitement thermique de type trempe, recuit et/ou bombage, c'est-à-dire de traitement thermique à une température supérieure à 200 °C.

Le substrat en verre peut être plat, incolore et/ou teinté. L'épaisseur du substrat est de préférence comprise entre 1 et 19 mm, plus particulièrement entre 2 et 10 mm, voire entre 3 et 6 mm.

Selon une variante de l'invention, la couche de protection temporaire peut servir à protéger le revêtement fonctionnel pendant une étape de dépôt d'un autre revêtement. Cet autre revêtement peut être déposé sur une partie de la surface principale du substrat portant le revêtement fonctionnel ou sur une partie de la surface principale du substrat ne portant pas le revêtement fonctionnel.

Il est notamment connu que pour l'obtention de substrats bi-fonctionnalisés portant un revêtement fonctionnel sur chaque face principale, le contact du revêtement fonctionnel déposé en premier avec les rouleaux du dispositif de dépôt durant le second passage permettant le dépôt du deuxième revêtement entraîne des altérations dommageables de la qualité du premier revêtement (pollution, rayures). Ces altérations devenant visibles après dépôt du deuxième revêtement fonctionnel et éventuellement trempe. L'invention permet de pallier à ce problème en protégeant le premier revêtement par une couche de protection destinée à disparaitre durant la trempe ou le bombage du substrat bi-fonctionnalisé.

Selon une autre variante de l'invention, la couche de protection temporaire peut servir à protéger la surface arrière du substrat pendant le dépôt d'un revêtement fonctionnel. En effet, le passage sur les rouleaux de la face arrière d'un substrat, par exemple en verre, lors du dépôt d'un revêtement fonctionnel, est susceptible d'altérer partiellement la dite surface (salissure, rayure). L'invention permet de pallier à ce problème en protégeant la surface arrière du substrat avant dépôt du premier revêtement.

La couche de protection temporaire peut être déposée :
- sur chacune des surfaces principales du substrat, et/ou
- sur au moins un bord du substrat, et/ou
- sur chacun des bords du substrat.

Lorsque la couche de protection temporaire est déposée sur chacune des surfaces principales du substrat et sur chacun des bords du substrat, la protection chimique et/ou mécanique est alors conférée sur l'entière surface du substrat.

La couche de protection temporaire peut être déposée sur un substrat en verre avant ou après une étape de découpe, c'est-à-dire sur un substrat en verre à la taille finale ou proche de la taille finale (primitif).

L'invention a encore pour objet un procédé de protection d'un article comprenant un substrat comprenant deux faces principales définissant deux surfaces principales séparées par des bords, ledit substrat en verre portant un revêtement fonctionnel déposé sur au moins une partie d'une surface principale, ledit procédé de protection comprenant les étapes suivantes :
- préparer une composition liquide comprenant des composés (méth)acrylates choisis parmi des monomères, des oligomères, des prépolymères ou des polymères comprenant au moins une fonction (méth)acrylate,
- appliquer la composition sur au moins une partie du revêtement fonctionnel de préférence à l'aide d'un rouleau, sur une épaisseur d'au moins 1 micromètre,
- réticuler la composition de façon à former la couche de protection temporaire.

Le procédé de protection comprend l'étape d'élimination de ladite couche de protection temporaire par un traitement thermique à température élevée. La température de traitement thermique est supérieure à 200 °C, supérieure à 300 °C, ou supérieure à 400 °C. Les traitements thermiques sont choisis parmi un recuit, par exemple par un recuit flash tel qu'un recuit laser ou flammage, une trempe, et/ou un bombage.

La composition liquide comprend de préférence moins de 20% en masse de solvant par rapport à la masse totale de la composition liquide et une viscosité comprise entre 0,05 et 5 Pa.s

Le procédé de protection d'un substrat comprend en outre une étape d'élimination de ladite couche de protection temporaire par un traitement thermique. Les traitements thermiques sont choisis parmi un recuit, par exemple par un recuit flash tel qu'un recuit laser ou flammage, une trempe, et/ou un bombage. La température de traitement thermique est supérieure à 200 °C, supérieure à 300 °C, ou supérieure à 400 °C.

Le traitement thermique nécessaire pour éliminer la couche de protection peut être un recuit dans un four statique ou dynamique. Le traitement thermique peut alors avoir pour objectif d'améliorer la cristallisation d'une ou plusieurs couches incluses dans l'empilement à protéger.

Le revêtement fonctionnel comprend au moins une couche fonctionnelle déposée lors d'une étape de dépôt par magnétron.

La couche de protection temporaire est formée immédiatement après l'étape de dépôt du revêtement fonctionnel. Selon l'invention, on considère que la couche de protection temporaire peut être formée « immédiatement après », lorsque la couche de protection temporaire peut être formée moins de 10 minutes, de préférence moins de 5 minutes et mieux moins de 1 minutes après l'étape de dépôt du revêtement fonctionnel.

La présente description concerne également une ligne de fabrication d'un article comprenant un substrat comprenant deux faces principales définissant deux surfaces principales séparées par des bords, ledit substrat portant :
- un revêtement fonctionnel déposé sur au moins une partie d'une surface principale et
- une couche de protection temporaire déposée sur au moins une partie du revêtement fonctionnel, obtenue à partir d'une composition liquide,
caractérisé en ce qu'il comporte :
i) un dispositif de dépôt d'un revêtement fonctionnel,
ii) un dispositif de dépôt d'une composition liquide comprenant un moyen de stockage et un moyen permettant l'application sous forme de couche de ladite composition liquide,
iii) un dispositif de réticulation par exemple thermique, par irradiation UV ou par faisceau d'électrons,
iv) des moyens permettant de déplacer ledit substrat des dispositifs i) à iii).

Le dispositif de dépôt d'un revêtement fonctionnel peut être un dispositif de dépôt par pyrolyse, un dispositif de dépôt par voie chimique et de préférence un dispositif de pulvérisation cathodique assistée par un champ magnétique (magnétron).

Le dispositif de dépôt d'une composition liquide comprenant un moyen de stockage et un moyen permettant l'application sous forme de couche de ladite composition liquide est de préférence un dispositif d'enduction au rouleau. Ce dispositif peut comprendre un rouleau d'application et un contre-rouleau. La composition liquide peut alors être amenée par pompage dans l'espace défini entre les deux rouleaux constituant un moyen de stockage et appliquée par entrainement des rouleaux.

De préférence, le dispositif de réticulation est une lampe UV.

Le substrat en verre protégé selon l'invention peut être empilé sans pollution croisée, ni apparition de rayures mécaniques, immédiatement après dépôt des revêtements fonctionnels.

Le substrat en verre protégé selon l'invention répond avantageusement aux critères suivants :
- protection mécanique à la rayure se traduisant par exemple par une résistance au test Erichsen à la pointe (EST) d'au moins 7 N et au test Clement supérieur à 20 N,
- protection aux sollicitations mécaniques de la transformation se traduisant par une résistance accrue du revêtement fonctionnel localisé sous la couche de protection au différent mode de stockage, à la brosse de machine à laver, au façonnage et à la découpe,
- protection à la corrosion humide, en particulier mécanisme de corrosion des couches d'argent soumises à la condensation d'un film d'eau durant le stockage ou le transport.
- résistance de la couche de protection durant la trempe pendant un temps suffisant pour que le verre reste hautement émissif durant un temps permettant un gain en énergie significatif,
- excellente adhésion de la couche de protection au revêtement fonctionnel pour supporter sans délamination toutes les étapes de transformation avant trempe,
- élimination de la couche de protection temporaire sans laisser de résidus minéralisés en cas de trempe ou de bombage quel que soit le type de chauffage (radiatif/convectif).

### EXEMPLES

### I. Matériaux utilisés

### 1. Substrats et couches fonctionnelles

Les substrats utilisés sont des substrats en verre plan d'environ 6 mm d'épaisseur obtenus par un procédé de flottage (" float ") qui consiste à déverser le verre en fusion sur un bain d'étain.

Des revêtements fonctionnels conférant des propriétés de contrôle solaire comprenant un empilement de couches minces ont été déposés grâce à un dispositif de pulvérisation cathodique assisté par champ magnétique (magnétron).

Le premier revêtement fonctionnel, appelé ci-après tri-couches Ag, comprend successivement à partir du substrat une alternance de trois couches d'argent (couches métalliques fonctionnelles) et de quatre revêtements antireflets, chaque revêtement antireflet comportant au moins une couche diélectrique, de manière à ce que chaque couche métallique fonctionnelle soit disposée entre deux revêtements antireflets. L'épaisseur totale de ce revêtement fonctionnel est comprise entre 200 et 250 nm.

Le deuxième revêtement fonctionnel, appelé ci-après bi-couches Ag, comprend un empilement de couches minces comportant successivement à partir du substrat une alternance de deux couches d'argent et de trois revêtements antireflets, chaque revêtement antireflet comportant plusieurs couches diélectriques, de manière à ce que chaque couche d'argent soit disposée entre deux revêtements antireflets. L'épaisseur totale de ce revêtement fonctionnel est comprise entre 150 et 200 nm.

La couche supérieure des premier et deuxième revêtements fonctionnels est choisie parmi :
- OC1 : une couche de nitrure de titane, de zirconium et de hafnium obtenue à partir de cibles de titane métallique, d'alliage métallique de titane et de zirconium ou d'alliage métallique de titane, zirconium et hafnium (TiZrHfNx) de 2 à 5 nm,
- OC2 : une couche d'oxyde de titane obtenue à partir d'une cible de titane métallique ou d'oxyde de titane TiOx sous stœchiométrique (x<2) de 2 à 5 nm ou
- OC3 : une couche de nitrure de silicium obtenue à partir d'une cible de silicium éventuellement dopé de 10 à 50 nm.

### 2. Couche de protection temporaire

Des compositions liquides ont été réalisées avec des mélanges d'oligomères et de monomères comprenant au moins une fonction acrylate commercialisés par la société Sartomer :
CN9276 : oligomère uréthane-acrylate aliphatique tétra-fonctionnel,
SR351 : triméthylolpropane triacrylate, monomère acrylate tri-fonctionnel,
SR833S : tricyclodécane diméthanol diacrylate, monomère acrylate di-fonctionnel.

La présence de l'oligomère uréthane-acrylate permet de moduler les propriétés de dureté et de souplesse de la couche de protection temporaire.

La couche de protection temporaire est ensuite durcie soit par séchage soit par réticulation aux UV. Un initiateur de polymérisation est ajouté et choisi en fonction du type de réticulation. Par exemple :
- pour une réticulation thermique, l'initiateur est du peroxyde de benzoyle,
- pour une réticulation UV, l'initiateur peut être choisi parmi les photo-initiateurs commercialisés par BASF sous la dénomination Irgacure^{®} tel que l'Iragure 500, par Lambson sous la dénomination Speedcure 500 ou par Lamberti sous la dénomination Esacure HB.

| Compositions | A | B | C | D |
|---|---|---|---|---|
| Constituant principaux : | | | | |
| - oligomère acrylate | 40 | 40 | 60 | 36 |
| - di-fonctionnel acrylate | 30 | 30 | 20 | 25 |
| - tri-fonctionnel acrylate | 30 | 30 | 20 | 25 |
| Initiateur : | | | | |
| - Thermique | 3 | - | - | - |
| - UV | - | 5 | 5 | 5 |
| Solvant : acétate de butyle | - | - | - | 9 |
| Viscosité à 25 °C(Pa.s) | 0,71 | 0,50 | 1,08 | 0,15 |

Les compositions sont définies en parties en masse.

Les constituants principaux sont constitués par les oligomères, monomères et éventuellement prépolymères.

Les compositions liquides sont appliquées sur les substrats en verre par enduction au rouleau. Des épaisseurs comprises entre 10 et 20 µm sont obtenues en utilisant des vitesses pour le rouleau applicateur comprises entre environ 15 et 25 m/min.

Les couches temporaires A durcies par séchage sont chauffées à 150°C pendant 15 min et ainsi parfaitement sèches et dures.

Les couches temporaires D sont préalablement séchées dans un four type IR à une température d'au moins 120°C mais inférieure à 170°C avant un passage sous UV pour réticulation.

Les couches temporaires B, C ou D durcies par irradiation UV sont réticulées à une vitesse de 15 m/min par un rayonnement UV fourni par une lampe à mercure de puissance 120 W. Dans ces conditions, la polymérisation du mélange de monomères et d'oligomères est obtenue dans la gamme d'épaisseur de 10 à 20 µm.

Les couches temporaires durcies par irradiation UV peuvent également être réticulées grâce à un système de réticulation LED UV.

### II. Evaluation des propriétés mécaniques

Ces essais ont été réalisés sur des substrats en verre portant :
- un revêtement fonctionnel tri-couches argent,
- une couche de protection temporaire de type C.

Les épaisseurs testées pour la couche fonctionnelle sont respectivement de 13 et 20 µm.

Les substrats sont soumis à une trempe thermique dans les conditions suivantes : 685-695°C pendant 40-50s/mm de verre. Puis, un test Erichsen à la Pointe (EST) et un test Haute Humidité (HH) sont réalisés.

Le test Erichsen consiste à reporter la valeur de la force nécessaire, en Newton, pour réaliser une rayure dans l'empilement (pointe de Van Laar, bille d'acier).

Les indicateurs d'appréciation suivants ont été utilisés :
«+++» : pas de rayure,
«0» : rayures non continues,
«--» : nombreuses rayures non continues,
«---» : rayure continues.

Le test humidité (HH) consiste à stocker des échantillons pendant 8 jours à 90 % de l'humidité relative et à 60 °C et à observer la présence éventuelle de défauts tels que des piqures de corrosion. Les indicateurs d'appréciation suivants ont été utilisés :
«+» : pas de piqure,
«-» : nombreuses piqures.

Les tableaux ci-dessous récapitulent les vitrages, les conditions d'évaluation et les indicateurs d'appréciation. Un substrat de référence portant un revêtement fonctionnel sans couche de protection temporaire est comparé à deux substrats portant un revêtement fonctionnel et une couche de protection temporaire de 13 et de 24 µm d'épaisseur. Le test a été réalisé sur deux endroits différents de la surface d'un même substrat. Ces exemples montrent clairement l'excellente résistance à la rayure et à la corrosion humide des substrats protégés selon l'invention.

| Test Erichsen | 0,1 | 0,5 | 0,7 | 1 | 3 | 5 | 7 | 10 |
|---|---|---|---|---|---|---|---|---|
| Référence | +++ | +++ | +++ | 0 | --- | --- | --- | --- |
| | +++ | +++ | +++ | 0 | --- | --- | --- | --- |
| C-13 µm | +++ | +++ | +++ | +++ | +++ | +++ | +++ | -- |
| | +++ | +++ | +++ | +++ | +++ | +++ | +++ | -- |
| C-24 µm | +++ | +++ | +++ | +++ | +++ | +++ | 0 | -- |
| | +++ | +++ | +++ | +++ | +++ | +++ | +++ | -- |

| Test HH | Appréciation |
|---|---|
| Référence | - |
| C-13 µm | + |
| C-24 µm | + |

Le substrat de référence selon le test Erichsen comprend dès 1 N de fines rayures et à 10 N de nombreuses rayures continues très visibles, homogènes en épaisseur. Un même substrat protégé par une couche de protection temporaire selon l'invention comprend beaucoup moins de rayures après trempe pour des forces appliquées de 7 à 10 N. De plus, les rayures sont non-continues.

Les substrats protégés par une couche de protection temporaire selon l'invention ne comprennent pas de piqure de corrosion. Ces essais montrent qu'un substrat portant un revêtement fonctionnel de 13 µm d'épaisseur est efficacement protégé.

### III. Evaluation des propriétés après trempe

Les essais de trempe réalisés montrent l'enlèvement total de la couche de protection temporaire sans détérioration des substrats portant les revêtements fonctionnels. Cet aspect a été vérifié en mesurant les coordonnées colorimétriques. Des substrats de verre portant des revêtements fonctionnels qui différent par le choix de la couche supérieure ont été testés. Ils comprennent respectivement comme couche supérieure OC1 (TiZrHfNx) et OC2 (TiOx).

Des substrats appelés ci-après OC1-Inv et OC2-Inv ont été protégés par un revêtement temporaire de type C et soumis à une trempe. Pour comparer, des substrats de référence appelés ci-après OC1-Ref et OC2-Ref n'ont pas été protégés et soumis à une trempe.

La variation colorimétrique au traitement thermique de couleur côté revêtement fonctionnel en réflexion induite par la trempe a été calculée (ΔE). Pour cela :
- les couleurs en réflexion L*, a* et b* dans le système LAB mesurées selon l'illuminant D65, côté couches sont mesurées et
- la variation est mesurée de la façon suivante : ΔE = (Δa*² + Δb*² + ΔL*²)^{½}.

Plusieurs mesures de ΔE ont été réalisées pour chaque substrat de verre recouvert d'un revêtement fonctionnel. Le tableau ci-dessous récapitule le résultat de ces essais.

Pour les substrats de référence, le ΔE représente la variation entre les valeurs L, a* et b* obtenues pour un substrat non protégé avant trempe et pour un substrat non protégé trempé.

Pour les substrats de l'invention, le ΔE correspond à la variation entre les valeurs L, a* et b* obtenues pour un substrat non protégé avant trempe et pour un substrat protégé dont la couche de protection a été éliminée suite à la trempe.

| **Substrat** | **OC1-Inv** | **OC1-Ref** | **OC2-Inv** | **OC2-Ref** |
|---|---|---|---|---|
| ΔE | 11,21 | 10,70 | 12,71 | 10,43 |
| | 11,15 | 11,13 | 12,51 | - |
| | 11,95 | 10,81 | 12,93 | - |

Ces essais montrent que la présence de la couche de protection temporaire selon l'invention ne modifie pas les variations colorimétriques pouvant être induite par un traitement de type trempe. En effet, la différence entre les valeurs de ΔE ne sont pas significatives entre un substrat selon l'invention et un substrat de référence trempés par rapport à un substrat non trempé.

Peu importe la nature de la couche supérieure, on n'observe pas de variation colorimétrique imputable à la présence de la couche de protection temporaire. Cela signifie que la couche de protection temporaire n'induit pas de modification colorimétrique dans le substrat après traitement thermique

### IV. Influence de la couche supérieure

Des essais comparatifs pour évaluer l'influence de la couche supérieure sur l'aspect après trempe ont été réalisés. Des substrats portant des revêtements fonctionnels de type tri-couches argent avec des couches supérieures différentes ont été testés. Chacun de ces substrat a été recouvert d'une couche de protection temporaire de type C puis soumis à un traitement thermique de type trempe.

Les observations de la surface après traitement thermique en fonction de la nature de la couche supérieure sont les suivantes :
- OC1 (TiZrHfNx) : aucun défaut,
- OC2 (TiOx) : aucun défaut,
- OC3 (Si3N4) : aucun défaut.

D'autres couches de supérieure ont été testées. Ces couches n'ont pas permis d'obtenir d'aussi bons résultats que ceux obtenus avec les nitrures, oxydes ou oxy-nitrures de titane, de zirconium et/ou d'hafnium. Des revêtements fonctionnels comprenant des couches supérieures à base de titane, zirconium et/ou hafnium protégés par des couches temporaires selon l'invention montrent une meilleure résistance à la corrosion et des niveaux de flou très faibles.

## Revendications

1. Article comprenant un substrat comprenant deux faces principales définissant deux surfaces principales séparées par des bords, ledit substrat portant :
- un revêtement fonctionnel déposé par pulvérisation cathodique assistée par un champ magnétique sur au moins une partie d'une surface principale et
- une couche de protection temporaire déposée sur au moins une partie du revêtement fonctionnel,
**caractérisé en ce que** :
- la couche de protection temporaire a une épaisseur d'au moins 1 micromètre,
- la couche de protection temporaire est non soluble dans l'eau,
- la couche de protection temporaire est obtenue à partir d'une composition comprenant des composés (méth)acrylates,
- le substrat portant le revêtement fonctionnel n'a pas subi de traitement thermique à une température supérieure à 400 °C.

2. Article comprenant un substrat selon la revendication 1 ou 2 **caractérisé en ce que** le substrat portant le revêtement fonctionnel n'a pas subi de traitement thermique à une température supérieure à 200 °C.

3. Article comprenant un substrat selon la revendication 1 **caractérisé en ce que** les composés (méth)acrylates ayant réagis rentre eux représentent au moins 90% en masse de la masse de la couche de protection temporaire.

4. Article comprenant un substrat selon l'une quelconque des revendications précédentes **caractérisé en ce que** le revêtement fonctionnel comprend un empilement de couches minces comportant successivement à partir du substrat une alternance de n couches métalliques fonctionnelles à base d'argent ou d'alliage métallique contenant de l'argent, et de (n+1) revêtements antireflets, chaque revêtement antireflet comportant au moins une couche diélectrique, de manière à ce que chaque couche métallique fonctionnelle soit disposée entre deux revêtements antireflets.

5. Article comprenant un substrat selon l'une quelconque des revendications précédentes **caractérisé en ce que** le revêtement fonctionnel comprend une couche supérieure choisie parmi les nitrures, oxydes ou oxy-nitrures de titane, de zirconium et/ou d'hafnium.

6. Article comprenant un substrat selon la revendication 5 **caractérisé en ce que** la couche supérieure est choisie parmi une couche :
- de nitrure de titane ; de nitrure de zirconium ; de nitrure d'hafnium ; de nitrure de titane et de zirconium ; de nitrure de titane, de zirconium et d'hafnium,
- d'oxyde de titane ; d'oxyde de zirconium ; d'oxyde d'hafnium ; d'oxyde de titane et de zirconium ; d'oxyde de titane, de zirconium et d'hafnium.

7. Article comprenant un substrat selon l'une quelconque des revendications précédentes **caractérisée en ce que** la couche de protection temporaire est déposée :
- sur chacune des surfaces principales du substrat et/ou
- sur au moins un bord du substrat et/ou
- sur chacun des bords du substrat.

8. Procédé de protection d'un article comprenant un substrat comprenant deux faces principales définissant deux surfaces principales séparées par des bords, ledit substrat en verre portant un revêtement fonctionnel déposé par pulvérisation cathodique assistée par un champ magnétique sur au moins une partie d'une surface principale,
le substrat portant le revêtement fonctionnel n'a pas subi de traitement thermique à une température supérieure à 400 °C,
ledit procédé de protection comprenant les étapes suivantes :
- préparer une composition liquide comprenant des composés (méth)acrylates choisis parmi des monomères, des oligomères, des prépolymères ou des polymères comprenant au moins une fonction (méth)acrylate,
- appliquer la composition sur au moins une partie du revêtement fonctionnel sur une épaisseur d'au moins 1 micromètre,
- réticuler la composition de façon à former la couche de protection temporaire non soluble dans l'eau.

9. Procédé de protection d'un article comprenant un substrat selon la revendication 8 **caractérisé en ce qu'**il comprend en outre une étape d'élimination de ladite couche de protection temporaire par un traitement thermique à température élevée de type trempe, recuit et/ou bombage, notamment à une température supérieure à 200 °C, supérieure à 300 °C, ou supérieure à 400 °C.

10. Procédé de protection d'un article comprenant un substrat selon la revendication 8 ou 9 **caractérisé en ce que** le revêtement fonctionnel est déposé par pulvérisation cathodique assistée par un champ magnétique et **en ce que** la couche de protection temporaire est directement au contact du revêtement fonctionnel.

11. Procédé de protection d'un article comprenant un substrat en verre selon l'une quelconque des revendications 8 à 10 **caractérisé en ce que** la composition liquide comprend moins de 20% en masse de solvant par rapport à la masse totale de la composition liquide et une viscosité comprise entre 0,05 et 5 Pa.s.

## Patentansprüche

1. Gegenstand, umfassend ein Substrat mit zwei Hauptseiten, die zwei durch Kanten getrennte Hauptflächen definieren, wobei das Substrat trägt:
- eine funktionelle Beschichtung, die durch magnetfeldunterstützte Kathodenzerstäubung auf mindestens einem Teil einer Hauptfläche aufgebracht ist, und
- eine temporäre Schutzschicht, die auf mindestens einem Teil der funktionellen Beschichtung aufgebracht ist,
**dadurch gekennzeichnet, dass**
- die temporäre Schutzschicht eine Dicke von mindestens 1 Mikrometer aufweist,
- die temporäre Schutzschicht nicht wasserlöslich ist,
- die temporäre Schutzschicht aus einer Zusammensetzung erhalten wird, die (Meth)acrylatverbindungen umfasst,
- das die funktionelle Beschichtung tragende Substrat keiner Wärmebehandlung bei einer Temperatur über 400 °C unterzogen wurde.

2. Gegenstand, umfassend ein Substrat nach Anspruch 1, **dadurch gekennzeichnet, dass** das die funktionelle Beschichtung tragende Substrat keiner Wärmebehandlung bei einer Temperatur über 200 °C unterzogen wurde.

3. Gegenstand, umfassend ein Substrat nach Anspruch 1 oder 2, **dadurch gekennzeichnet, dass** die (Meth)acrylatverbindungen, die miteinander reagiert haben, mindestens 90 Masse-% der Masse der temporären Schutzschicht ausmachen.

4. Gegenstand, umfassend ein Substrat nach einem der vorhergehenden Ansprüche, **dadurch gekennzeichnet, dass** die funktionelle Beschichtung ein Dünnschichtsystem umfasst, das aufeinanderfolgend ab dem Substrat im Wechsel n metallische Funktionsschichten auf der Basis von Silber oder einer Metalllegierung, die Silber enthält, und (n+1) Entspiegelungsbeschichtungen umfasst, wobei jede Entspiegelungsbeschichtung mindestens eine dielektrische Schicht umfasst, sodass jede metallische Funktionsschicht zwischen zwei Entspiegelungsbeschichtungen angeordnet ist.

5. Gegenstand, umfassend ein Substrat nach einem der vorhergehenden Ansprüche, **dadurch gekennzeichnet, dass** die funktionelle Beschichtung eine Deckschicht umfasst, die aus Nitriden, Oxiden oder Oxynitriden von Titan, Zirconium und/oder Hafnium ausgewählt ist.

6. Gegenstand, umfassend ein Substrat nach Anspruch 5, **dadurch gekennzeichnet, dass** die Deckschicht aus einer Schicht ausgewählt ist aus:
- Titannitrid; Zirconiumnitrid; Hafniumnitrid; Titan- und Zirconiumnitrid; Titan-, Zirconium- und Hafniumnitrid,
- Titanoxid; Zirconiumoxid; Hafniumoxid; Titan- und Zirconiumoxid; Titan-, Zirconium- und Hafniumoxid.

7. Gegenstand, umfassend ein Substrat nach einem der vorhergehenden Ansprüche, **dadurch gekennzeichnet, dass** die temporäre Schutzschicht abgeschieden wird:
- auf jeder der Hauptflächen des Substrats und/oder
- auf mindestens einer Kante des Substrats und/oder
- auf jeder der Kanten des Substrats.

8. Verfahren zum Schützen eines Gegenstands, umfassend ein Substrat mit zwei Hauptseiten, die zwei durch Kanten getrennte Hauptflächen definieren, wobei das Glassubstrat eine funktionelle Beschichtung trägt, die durch magnetfeldunterstützte Kathodenzerstäubung auf mindestens einem Teil einer Hauptfläche aufgebracht ist, wobei das die funktionelle Beschichtung tragende Substrat keiner Wärmebehandlung bei einer Temperatur über 400 °C unterzogen wurde, wobei das Schutzverfahren die folgenden Schritte umfasst:
- Herstellen einer flüssigen Zusammensetzung, umfassend (Meth)acrylatverbindungen, ausgewählt aus Monomeren, Oligomeren, Prepolymeren oder Polymeren mit mindestens einer (Meth)acrylatfunktion,
- Auftragen der Zusammensetzung auf mindestens einen Teil der funktionellen Beschichtung in einer Dicke von mindestens 1 Mikrometer,
- Vernetzen der Zusammensetzung, sodass die temporäre Schutzschicht gebildet wird, die nicht wasserlöslich ist.

9. Verfahren zum Schützen eines Gegenstands, der ein Substrat nach Anspruch 8 umfasst, **dadurch gekennzeichnet, dass** es überdies einen Schritt zum Entfernen der temporären Schutzschicht durch eine Hochtemperatur-Wärmebehandlung vom Typ thermisches Vorspannen, Tempern und/oder Biegen, insbesondere bei einer Temperatur über 200 °C, über 300 °C oder über 400 °C, umfasst.

10. Verfahren zum Schützen eines Gegenstands, umfassend ein Substrat nach Anspruch 8 oder 9, **dadurch gekennzeichnet, dass** die funktionelle Beschichtung durch magnetfeldunterstützte Kathodenzerstäubung abgeschieden wird, und dass die temporäre Schutzschicht direkt mit der funktionellen Beschichtung in Kontakt steht.

11. Verfahren zum Schützen eines Gegenstands, umfassend ein Glassubstrat nach einem der Ansprüche 8 bis 10, **dadurch gekennzeichnet, dass** die flüssige Zusammensetzung weniger als 20 Masse-% Lösungsmittel, bezogen auf die Gesamtmasse der flüssigen Zusammensetzung, und eine Viskosität zwischen 0,05 und 5 Pa.s aufweist.

## Claims

1. An article comprising a substrate comprising two main faces defining two main surfaces separated by edges, said substrate bearing:
- a functional coating deposited by magnetron sputtering on at least one portion of one main surface and
- a temporary protective layer deposited on at least one portion of the functional coating,
**characterized in that**:
- the temporary protective layer has a thickness of at least 1 micrometer,
- the temporary protective layer is not soluble in water,
- the temporary protective layer is obtained from a composition comprising (meth)acrylate compounds,
- the substrate bearing the functional coating has not undergone a heat treatment at a temperature above 400°C.

2. The article comprising a substrate as claimed in claim 1, **characterized in that** the substrate bearing the functional coating has not undergone a heat treatment at a temperature above 200°C.

3. The article comprising a substrate as claimed in claim 1 or 2, **characterized in that** the (meth)acrylate compounds that have reacted together represent at least 90% by weight of the weight of the temporary protective layer.

4. The article comprising a substrate as claimed in any one of the preceding claims, **characterized in that** the functional coating comprises a thin-film multilayer successively comprising, starting from the substrate, an alternation of n functional metallic layers based on silver or on a metal alloy containing silver, and of (n+1) antireflection coatings, each antireflection coating comprising at least one dielectric layer, so that each functional metallic layer is positioned between two antireflection coatings.

5. The article comprising a substrate as claimed in any one of the preceding claims, **characterized in that** the functional coating comprises an upper layer selected from nitrides, oxides or oxynitrides of titanium, of zirconium and/or of hafnium.

6. The article comprising a substrate as claimed in claim 5, **characterized in that** the upper layer is selected from a layer:
- of titanium nitride; of zirconium nitride; of hafnium nitride; of titanium zirconium nitride; of titanium zirconium hafnium nitride,
- of titanium oxide; of zirconium oxide; of hafnium oxide; of titanium zirconium oxide; of titanium zirconium hafnium oxide.

7. The article comprising a substrate as claimed in any one of the preceding claims, **characterized in that** the temporary protective layer is deposited:
- on each of the main surfaces of the substrate and/or
- on at least one edge of the substrate and/or
- on each of the edges of the substrate.

8. A process for protecting an article comprising a substrate comprising two main faces defining two main surfaces separated by edges, said glass substrate bearing a functional coating deposited by magnetron sputtering on at least one portion of one main surface,
the substrate bearing the functional coating has not undergone a heat treatment at a temperature above 400°C said protection process comprising the following steps:
- preparing a liquid composition comprising (meth)acrylate compounds selected from monomers, oligomers, prepolymers or polymers comprising at least one (meth)acrylate function,
- applying the composition to at least one portion of the functional coating over a thickness of at least 1 micrometer,
- crosslinking the composition so as to form the temporary protective layer not soluble in water.

9. The process for protecting an article comprising a substrate as claimed in claim 8, **characterized in that** it additionally comprises a step of removing said temporary protective layer by a heat treatment at high temperature of tempering, annealing and/or bending type, especially at a temperature above 200°C, above 300°C, or above 400°C.

10. The process for protecting an article comprising a substrate as claimed in claim 8 or 9, **characterized in that** the functional coating is deposited by magnetron sputtering and **in that** the temporary protective layer is directly in contact with the functional coating.

11. The process for protecting an article comprising a glass substrate as claimed in any one of claims 8 to 10, **characterized in that** the liquid composition comprises less than 20% by weight of solvent with respect to the total weight of the liquid composition and a viscosity between 0.05 and 5 Pa.s.
